# EUROPEAN PATENT APPLICATION

(11) **EP 0 657 918 A2**
(43) Date of publication of application: **14.06.1995**
(21) Application number: 94308399.8
(22) Date of filing: 11.11.1994
(51) Int. Cl.: H01L 21/00

(54) **Method and apparatus for baking and cooling semiconductor wafers and the like**

(30) Priority: 12.11.1993 US 152037
(71) Applicant: SEMICONDUCTOR SYSTEMS, INC., Fremont, California 94539 (US)
(72) Inventor: Batchelder, William T., San Mateo, California 94402 (US)
(74) Representative: Freeman, Jacqueline Carol

(57) **Abstract**

A method and apparatus for quickly and uniformly baking and cooling semiconductor wafers, flat panels for flat panel displays, and the like, in which a wafer or flat panel is placed in close proximity to a hotplate and a thermally conductive, non-reactive gas, such as helium, is introduced into the airspace between the wafer or flat panel and the hotplate. The thermally conductive, non-reactive gas, in one embodiment, is preheated before introduction into the airspace between the wafer or flat panel and the hotplate, by being passed through a bore through the hotplate. Additionally, the wafer is automatically aligned in a milled recession in the hotplate surface for future handling.

## Description

This disclosure relates to the field of the semiconductor fabrication, and in particular, to an improved method and apparatus for baking semiconductor wafers and the like to a desired temperature quickly and evenly.

In the art of the semiconductor fabrication, it is often necessary to bake a semiconductor wafer or similar article, e.g. a large, flat panel for a flat panel display, which has been coated with a chemical, such as photoresist, to a desired temperature so as to cure the chemical. For example, semiconductor wafers are typically heated to a temperature of 100°C to cure a coating of photoresist chemical. The particular temperature which is desired is dependent upon the particular chemical coating the wafer or flat panel, the thickness of the chemical coating, and the desired effect.

In the prior art, hotplates were used to bake wafers. For example, a wafer that was coated on one side with a chemical, such as photoresist, was placed on a hotplate, such that the uncoated side of the wafer was in direct contact with the hotplate. The wafer was held in position by applying a vacuum to the underside of the wafer through bores drilled into the hotplate. The hotplate was then heated to 100°C to thereby bake the wafer, bringing the wafer up to 100°C.

This baking system of the prior art posed two problems: First, since the uncoated side, i.e., the "backside", of the wafer would often be contaminated with chemical, the hotplate, which was in direct contact with the uncoated side of the wafer, likewise became contaminated with chemical. Therefore, the hotplate would require frequent cleaning, requiring frequent breaks in the semiconductor manufacturing process.

Second, as the wafer was in direct contact with the hotplate, the wafer is susceptible to contamination on the backside of the wafer. Particulates on the backside of the wafer often cause focus errors during the resist exposure process. In cases where higher temperatures are used, sudden contact of the heated hotplate with the wafer can cause thermal shock which sometimes leads to warping or fracturing of the substrate.

For these reasons, semiconductor manufacturing has moved towards a "proximity bake", in which the wafer is spaced from the hotplate by three support posts, so as to leave a 5 mil gap between the wafer and the hotplate. This prevents backside contamination by avoiding direct contact between the backside of the wafer and the hotplate. Prevention of backside contamination reduces the likelihood of focus errors and thermal shock. However, two problems are presented by previously known proximity bake systems. First, the support posts which support the wafer above the hotplate interfere with the baking process by causing uneven baking at the points on the wafer which are in contact with support posts. Second, considerably more time is required to heat the wafer to the desired temperature. For example, forty-five (45) seconds is typically required to bring a wafer to 100°C when spaced 5 mils from a hotplate at 100°C. In addition, convection can cause uneven heating at the wafer edge as the air between the wafer and the hotplate expands as a result of the heating of the air.

One known solution to the problem of the additional required bake time in proximity baking is to heat the hotplate to a higher temperature, e.g., 150°C. This hotter temperature brings the wafer to the desired temperature, e.g., 100°C, much more quickly. However, the thermal uniformity of the hotplate degrades as the temperature is increased. In addition, true thermal equilibrium is never fully attained in a reasonable process time. As a result, the temperature throughout the wafer is less uniform and changes throughout the baking process. In other words, some places of the wafer are too cold and other places of the wafer are too hot to properly effectuate an even cure of the chemical coating.

The substantial increase in bake time associated with proximity bake processes is particularly undesirable as increased bake time reduces the number of semiconductor wafers or other substrates that can be produced in a given time period, e.g. one day. Similarly, delays and resist exposure errors, which are caused by chemical contamination of the hotplate or the backside of the wafer, associated with contact baking of the prior art described above substantially reduce the number of semiconductor wafers that can be produced in a given time period and can reduce useful product yield.

A third problem arises during proximity baking of wafers if the wafer being baked has a slight warp. Some portions of the wafer are spaced further from the hotplate than other portions as a result of the warp of the wafer. Accordingly, those portions of the wafer further from the hotplate heat more slowly than the portions of the wafer nearer to the hotplate. Thus, warped wafers are not uniformly heated by proximity bake systems of the prior art.

The problems described above are equally applicable to the process by which the wafer is cooled for subsequent exposure of the photoresist. Typically, the wafer is placed on a chill plate which absorbs heat from the wafer and quickly brings the temperature of the wafer to room temperature. However, placing the wafer directly on the chill plate poses the same potential of backside contamination of the wafer described above with respect to hotplates. To prevent backside contamination, a proximity chill is used in which the wafer is supported by a number of support posts above a chill plate. Proximity chill suffers from the same slowness of heat transfer as described above with respect to proximity bake methods.

According to one aspect of the present invention there is provided a method comprising:
placing a substantially flat article in proximity to a hotplate, which has a desired temperature, so as to form an airspace therebetween; and
introducing a thermally conductive, non-reactive gas into the airspace.

A second aspect provides an apparatus for heating a substantially flat article to a desired temperature, the apparatus comprising:
a hot plate, mounted on a support structure, having a top side;
means for heating the hotplate to the desired temperature;
support means on the top side of the hotplate for supporting the flat article in proximity to the hotplate and creating an airspace between the flat article and the hotplate;
a thermally conductive, non-reactive gas source connected to the support structure; and
means for introducing an amount of thermally conductive, non-reactive gas from the gas source into the airspace.

Yet a third aspect of the invention provides an apparatus for cooling a substantially flat article to a desired temperature, the apparatus comprising:
a chill plate, mounted on a support structure and having a desired temperature, having a top side;
support means on the top side of the hotplate for supporting the flat article in proximity to the hotplate and creating an airspace between the flat article and the chill plate;
a thermally conductive, non-reactive gas source connected to the support structure; and
means for introducing an amount of thermally conductive, non-reactive gas from the gas source into the airspace.

Hence it will be appreciated that the disadvantage of the contact bake systems and the proximity bake of the prior art can be overcome by the present invention which requires introducing a thermally conductive, non-reactive gas into the airspace between the wafer and the hotplate. A "non-reactive" gas is a gas that does not readily react with the chemical coating of the wafer during the curing process. Helium is a particularly good thermally conductive, non-reactive gas and is both readily available and inexpensive. Helium in the airspace between the wafer and the hotplate produces a much more uniform heating of the wafer than did proximity bake systems of the prior art, reducing any anomalies in the heating of the wafer near points in contact with the support posts and transferring heat to areas of the wafer that are of increased distance from the hotplate as a result of a warp in the wafer. Furthermore, as helium is a particularly efficient energy transfer medium, the time required to heat the wafer to the desired temperature, as well as the time required to cool the wafer, is reduced by two-thirds or more.

In one embodiment, helium is heated to the desired temperature, e.g. 100°C, prior to introduction into the airspace between the wafer and the hotplate. In a particular embodiment, this preheating of the helium is accomplished by forcing the helium through a bore which passes through the hotplate, thereby forcing the helium to travel through the hotplate for a particular distance. For example, in the preferred embodiment, helium travels through the hotplate for a distance of at least two inches.

For a better understanding of the invention, reference will now be made, by way of example, to the accompanying drawings, in which:
Fig. 1 is a cross-sectional view of a proximity bake system in accordance with the present invention.
Fig. 2 is a cross-sectional view of a hotplate and a schematic view of a helium supply in accordance with one embodiment of the present invention.
Fig. 3 is a plan view of the hotplate of Figure 2.
Figs. 4A and 4B are cross-sectional views of a hotplate formed in accordance with the second described embodiment of the present invention.
Fig. 5 is a cross-sectional view of a hotplate formed in accordance with the third described embodiment of the present invention.
Figs. 6A and 6B are cross-sectional views of a hotplate formed in accordance with the fourth described embodiment of the present invention. Fig. 6C is a plan view of the hotplate of Figs. 6A and 6B.

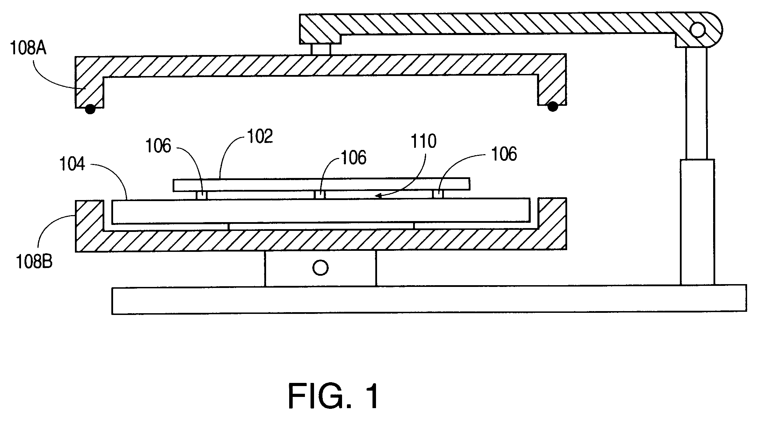

A wafer 102 (Fig. 1) is spaced from a hotplate 104 by about 5 mils by support posts 106. As is commonly done in the art, hotplate 104 is heated to 100°C. Many semiconductor processing systems in which the temperature of a hotplate is controlled are currently available. The Orbitrack system available from Semiconductor Systems, Inc. of Fremont, California is such a system. To facilitate heat transfer from hotplate 104 to wafer 102, helium gas is introduced into an airspace 110 between wafer 102 and hotplate 104.

While helium is used in disclosed embodiment, any gas may be used so long as the gas is particularly efficient as an energy transfer medium and will not react with the chemical coating on wafer 102. A gas is particularly efficient as an energy transfer medium if the gas has a thermal conductivity which is approximately equal to or greater than 100 cal/(sec)(cm²)(°C/cm) X 10⁻⁶ at a temperature of 100°F. Such a gas is called herein a "thermally conductive gas". Helium is a particularly efficient energy transfer medium as helium has a thermal conductivity of 368.63 cal/(sec)(cm²)(°C/cm) X 10⁻⁶ at a temperature of 100°F. Air, by contrast, has a thermal conductivity of 64.22 cal/(sec)(cm²)(°C/cm) X 10⁻⁶ at a temperature of 100°F. Furthermore, as helium is an inert gas, helium will not react with any chemical coating on wafer 102. A gas which will not readily react with the chemical coating of wafer 102 is herein called a "non-reactive gas". Additionally, helium is readily available and inexpensive. Thus, helium is used in the preferred embodiment.

Some thermally conductive gases are listed in Table A below.

**TABLE A**

| Gas | Thermal Conductivity¹ |
|---|---|
| Helium | 368.63 |
| Hydrogen | 458.72 |
| Deuterium | 343.01 |
| Neon | 118.19 |
| Air | 64.22 |

| | |
|---|---|
| ¹ As above, the thermal oonductivity is listed in units of cal/(sec)(cm²)(°C/cm) X 10⁻⁶ for a temperature of 100°F. | |

As helium has a particularly high thermal conductivity, the helium gas in airspace 110 between hotplate 104 and wafer 102 serves as a particularly efficient energy transfer medium between hotplate 104 and wafer 102. As a result, in one embodiment of the present invention, the time required to bring wafer 102 from room temperature to 100°C is reduced from forty-five (45) seconds without helium in airspace 110 to thirteen (13) seconds with helium in airspace 110. A similar reduction is observed in the time required for the wafer to cool when in proximity to a chill plate (not shown). Thus, three times as many wafers can be processed according to disclosed embodiment of the present invention as can be processed according to previously existing proximity bake systems.

Furthermore, as helium is a particularly efficient energy transfer medium, helium in airspace 110 produces a much more uniform heating of wafer 102 than did proximity bake systems of the prior art. Helium in airspace 110 reduces any anomalies in the heating of wafer 102 near points in contact with support posts 106. In addition, helium gas generally rises, thereby naturally flowing to areas of wafer 102 that are of increased distance from hotplate 104 as a result of a warp in wafer 102. These areas of wafer 102 that were typically insufficiently heated in previously known proximity bake systems are sufficiently and efficiently heated by the heat transfer properties of the helium. Thus, helium in airspace 110 provides a substantial improvement over the known bake systems in the uniformity of the heating of wafer 102.

While wafer 102 is baking in proximity to hotplate 104, a lid 108A is lowered so as to form a sealed chamber with a support structure 108B, thereby containing the helium gas and the heat of hotplate 104.

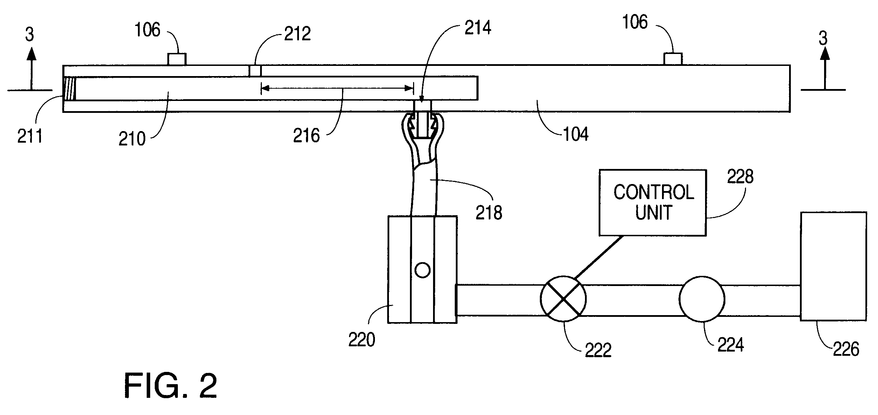

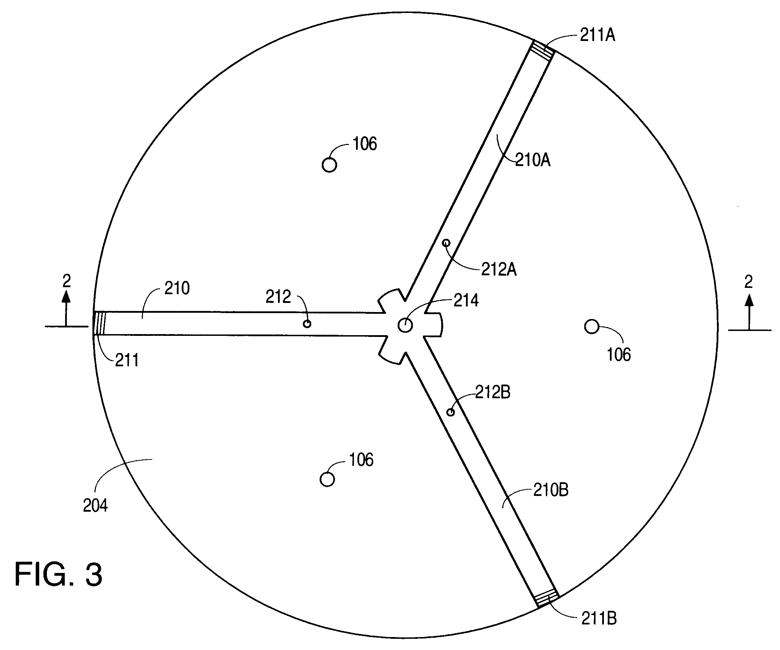

Hotplate 104 is shown in greater detail in Figs. 2 and 3. Hotplate 104 is gun drilled from the edge of hotplate 104 through its center to form a radial bore 210. Similarly, radial bores 210A and 210B (Fig. 3) are drilled. Plugs 211, 211A, and 211B seal the ends of radial bores 210, 210A, and 210B, respectively. A center bore 214 is drilled through the bottom of hotplate 104 so as to allow helium to be introduced into radial bores 210, 210A and 210B. A top bore 212 (Fig. 2) is drilled through the top of hotplate 104 into radial bore 210. Top bore 212 is spaced from center bore 214 by a distance 216, such that helium introduced through center bore 214 travels along radial bore 210 for a distance of at least distance 216. As helium flows from center bore 214 along distance 216 of radial bore 210 to top bore 212, the helium is heated to the temperature of hotplate 104. Thus, helium flowing through top bore 212 into airspace 110 (Figure 1) is the same temperature as that of hotplate 104.

In one embodiment, distance 216 (Figure 2) is at least 2 inches and the diameter of top bore 212 is 2 mils. Top bores 212A and 212B (Fig. 3) are drilled through the top of hotplate 104 into radial bores 210A and 210B, respectively, in the manner described above with respect to top bore 212.

In a second embodiment, an additional top bore (not shown) is drilled directly over center bore 214. Helium flowing through this center top bore is not as thoroughly preheated as is helium flowing through top bores 212, 212A and 212B.

Some hotplates used in the prior art applied a vacuum hold-down using radial bores, top bores and a center bore which were drilled as described above with respect radial bores 210, 210A, and 210B; top bores 212, 212A, and 212B; and center bore 214. In such hotplates, helium is introduced through the bores to which a vacuum was applied in the prior art. In hotplates having numerous top bores, helium may flow through only one or a few of the top bores, causing wafer 102 to be heated non-uniformly. It is preferred that a sufficient number of the top bores of such a hotplate be plugged such that helium flows through top bores which are sufficiently distributed to uniformly fill airspace 110 with helium.

Helium is introduced into hotplate 104 from a helium source 226 (Fig. 2). Helium source 226 can be an ordinary bottle of pressurized helium available from Airco Products of San Leandro, California. A valve 224 controls the rate at which helium flows from helium source 226. In one embodiment, valve 224 is adjusted by hand to provide a flow rate just insufficient for form an air bearing under wafer 102 as described below. It is appreciated that known and available electronically controlled valves can be used in as valve 224. The flow of helium from helium source 226 is controlled by a solenoid valve 222 and the rate at which helium flows from helium source 226 is monitored by flow meter 220. Helium flows from helium source 226 through valve 224, solenoid valve 222, flow meter 220, and a tube 218 through center bore 214 into radial bores 210, 210A and 210B of hotplate 104. In one embodiment, solenoid valve 222 is controlled by a control unit 228.

Solenoid valve 222, in one embodiment, is the EV0-3-12DVC solenoid valve supplied by Clippard Laboratories of Cincinnati, Ohio. Flow meter 220 can be the B-433 flow meter available from the Porter Instrument Company of Hatfield, Pennsylvania. The B-433 flow meter can measure flow rates ranging from zero (0) to thirty-two (32) cc/minute. The B-433 flow meter is not designed for use with helium and some helium leaks from the B-433 flow meter when used as flow meter 220. However, many flow meters which are designed for use with helium are known and available in the art and such flow meters can be used as flow meter 220.

The use of control unit 228 to control solenoid valve 222 is known and a control unit capable of controlling solenoid valve is used in the Orbitrack system available from Semiconductor Systems, Inc. of Fremont, California.

In one embodiment, helium flows from helium source 226 at a rate of about 3 cubic centimeters per minute. In this embodiment, helium flows at a rate just below that which forms an air bearing below wafer 102 (Fig. 1). The appropriate flow rate is determined by increasing the flow rate of helium until an air bearing forms under wafer 102 (typically 2-4 cc/minute), causing wafer 102 to move with respect to hotplate 104. The flow rate of the helium is then decreased until wafer 102 no longer floats on an air bearing.

Areas of the chemical coating of wafer 102 which are directly above top bores 212, 212A and 212B (Fig. 3) tend to cure more quickly than other areas of the chemical coating of wafer 102. Thus, in other embodiments, helium is pulsed into airspace 110 by repeatedly turning on the flow of helium for a period of time and then turning off the flow of helium for a period of time. By periodically stopping the flow of helium into airspace 110, the helium is allowed to disperse throughout airspace 110 to provide a more even heating of wafer 102. In a particular embodiment, helium is introduced into airspace 110 at a rate of fifteen (15) to twenty (20) cubic centimeters per minute for a period of two seconds and then shut off for a period of two seconds. In some embodiments, helium is introduced through top bores 212, 212A and 212B prior to placing wafer 102 support posts 106. This early introduction of helium speeds the heating of wafer 102 and minimizes any premature, non-uniform heating of wafer 102 as a result of being placed in contact with support posts 106, which may be hot as a result of a previous bake.

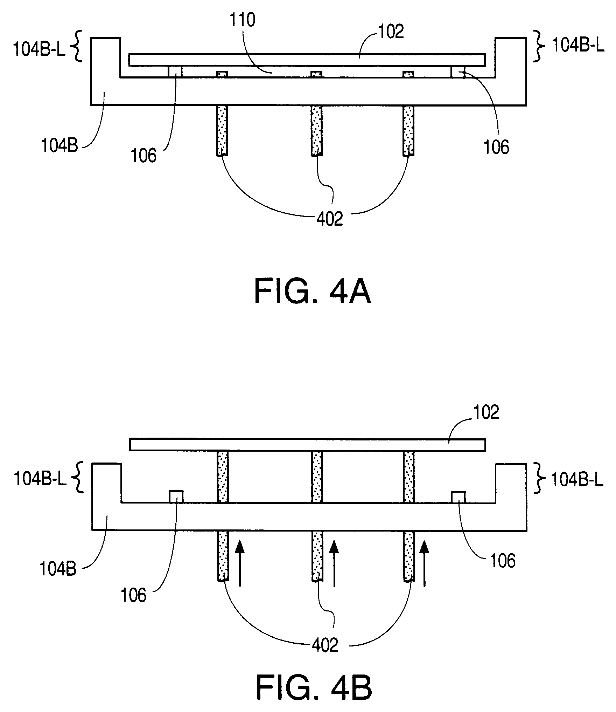

A second embodiment of a hotplate according to the principles of the present invention is shown in Figs. 4A and 4B. Hotplate 104B has a lip 104B-L around the periphery of wafer 102 to form a well or bowl in which wafer 102 sits. Lip 104B-L reduces the leakage of helium from airspace 110 between wafer 102 and hotplate 104B. Wafer 102 (Fig. 4B) is lifted above lip 104B-L after the proximity bake by lift pins 402 which are positioned in holes (not shown) through hotplate 104B and which are slidably moveable in the vertical direction. Such lift pins are commonly used in proximity bake systems currently available, e.g., the Orbitrack system available from Semiconductor Systems, Inc. of Fremont, California. Similarly, wafer 102 is lowered below lip 104B-L into the position shown in Fig. 4A prior to the proximity bake by lift pins 402.

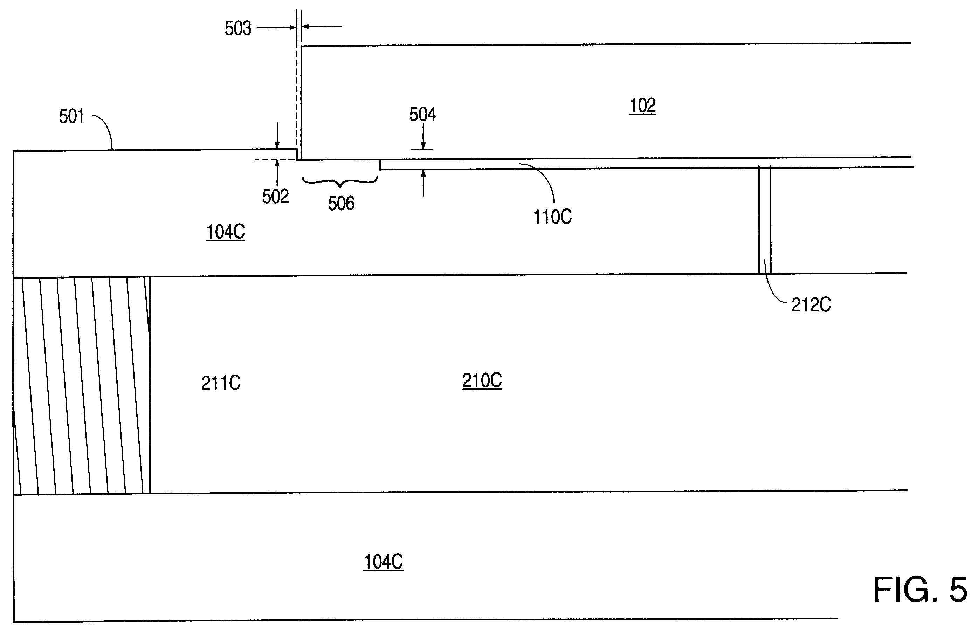

A third embodiment of a hotplate in accordance with the principles of the present invention is shown in Figure 5. Radial bore 210C, top bore 212C, and plug 211C of hotplate 104C are formed generally as described above with respect to Figure 2. The top surface 501 of hotplate 104C is milled to a depth 502 such that wafer 102 will sit in the milled area with a gap of a distance 503 around the perimeter of wafer 102 and the unmilled portion of surface 501. In one embodiment, depth 502 is 5 mils and distance 503 is ten (10) mils. Hotplate 104C is again milled to a depth 504 so as to leave a bench 506 to support wafer 102 and leave an airspace 110C between hotplate 104C and wafer 102. In one embodiment, bench 506 has a width of one-tenth of an inch, and depth 504 is 10 mils so as to leave a distance of 5 mils between wafer 102 and hotplate 104C. As described above with respect to hotplate 104B (Figures 4A and 4B), lift pins (not shown in Figure 5) lift wafer 102 (Figure 5) out of and lower wafer 102 into the milled area of hotplate 104C.

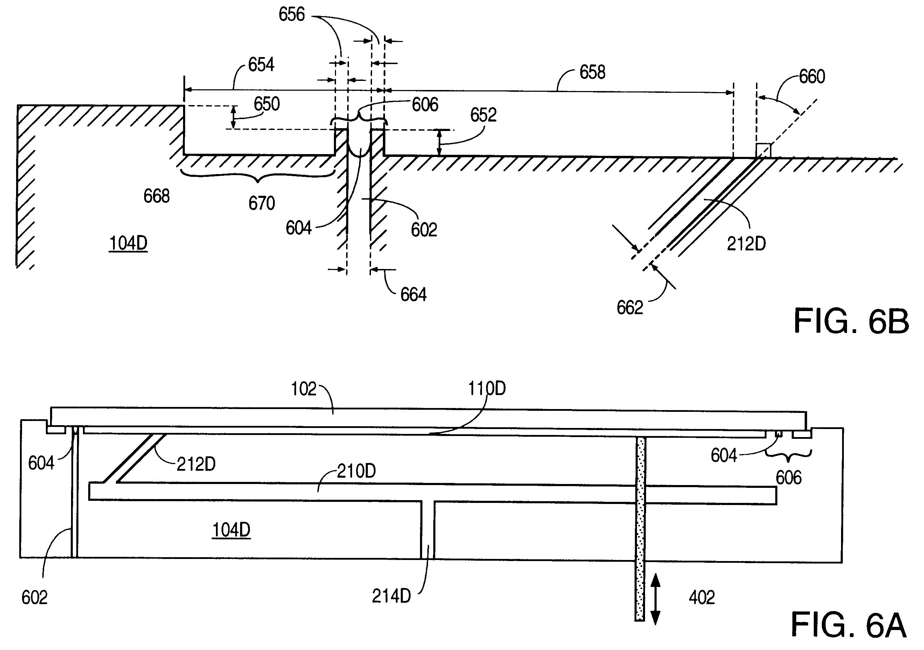

A fourth embodiment of a hotplate according to the principles of the present invention is shown in Figures 6A-6C. Hotplate 104D has no gun drilled radial bores but instead has a cylindrical chamber 210D which is formed inside and is concentric with hotplate 104D. Helium is introduced into chamber 210D through center bore 214D. Top bore 212D is angled toward the center of hotplate 104D. Wafer 102 sits on a bench 606 which is formed as described above with respect to bench 506 (Figure 5). In bench 606 (Figure 6A), an annular groove 604 is formed. A vacuum bore 602 is drilled through hotplate 104D into annular groove 604. A relative vacuum is applied to reduce the air pressure in annular groove 604 through vacuum bore 602 to hold wafer 102 tightly against bench 606 of hotplate 104D.

As is the case with hotplate 104C (Figure 5), hotplate 104D (Figure 6B) is milled to a depth 650 of 5 mils and is further milled to a depth 652 of an additional 5 mils to form bench 606 whose inner edge is a distance 654 of one-tenth (0.1) of an inch from outer edge 668 of the well. Hotplate 104D is further milled in a area 670 between the inner edge of bench 606 and the outer edge 668 of the well. Annular groove 604 is placed in the center of bench 606 leaving a narrow portion of the surface of bench 606 of a width 656 of approximately thirty (30) mils on either side of annular groove 604. If distance 656 is excessively narrow, hotplate 104D becomes susceptible to physical damage and wear. Annular groove 604 has a width 664 of approximately sixty (60) mils.

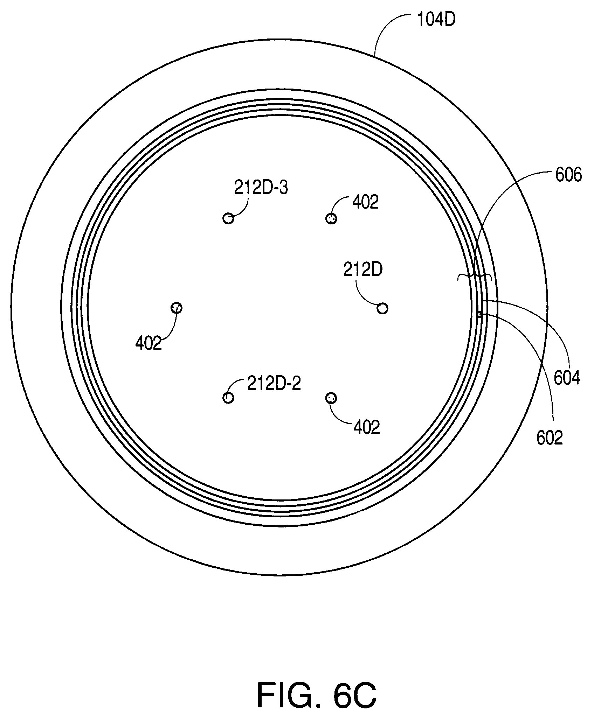

Milling hotplate 104D between bench 606 and outer edge 668, i.e., in area 670, reduces backside contact with wafer 102 at the outer most edge of wafer 102. It is important that bench 606 be positioned some distance from the outer edge of wafer 102 since backside contamination of wafer 102 at the position of contact near annular groove 604 can reduce the effectiveness of vacuum hold-down and backside contamination is most likely at the outer edge of wafer 102. Wafer 102 is lifted on to and off of bench 606 by lift pins 402 (Figures 6A and 6C) as described above with respect to Figures 4A and 4B.

Top bore 212D is drilled at a position which is a distance 658 of approximately 1 centimeter or 0.39 inches from bench 606. Top bore 212D is drilled at an angle 660 of approximately 45° from perpendicular to the surface of hotplate 104D. Top bore 212D is angled toward the center of hotplate 104D. The diameter 662 of top bore 212D is approximately 2 mils.

Figure 6C is a top view of hotplate 104D. Annular groove 604 in bench 606 is shown with vacuum bore 602. A total of three top bores, i.e., top bores 212D, 212D-2, and 212D-3, are angled toward the center of hotplate 104D. A wafer is automatically centered on bench 606 by alternatively (i) filling airspace 110D (Figure 6A) with sufficient helium to lift wafer 102 from bench 606 and (ii) applying a relative vacuum to vacuum bore 602 to firmly hold wafer 102 against bench 606. The sequence of lifting and then firmly holding wafer 102 is repeated five (5) times to ensure that wafer 102 is centered on bench 606.

Since annular groove 604 (Figure 6C) applies a relative vacuum to wafer 102 (not shown in Figure 6C) around the entire periphery of wafer 102, a small warp in wafer 102 is reduced or eliminated during the baking process. Additionally, back side contamination near the center of wafer 102 is eliminated as no support posts are used. Since wafers are generally held by vacuum clamps near the centers of the wafers during semiconductor wafer manufacturing, it is more important to eliminate backside contamination near the center of a wafer than near the edge of the wafer. However, with larger wafers, such as large, flat panels for flat panel displays, a support post (not shown) is placed in the center of hotplate 104D to prevent warping of and to support wafer 102.

The principles of the present disclosure are equally applicable to improving the cooling of semiconductor wafers immediately subsequent to baking. For example, hotplate 104D (Figure 6A) can be used as a chill plate. To use hotplate 104D as a chill plate, hotplate 104D is kept at room temperature. Wafer 102 is placed on hotplate 104D and centered as described above. Wafer 102 is held in place by a relative vacuum applied to annular groove 604 through vacuum bore 602. A thermally conductive, non-reactive gas such as helium is introduced through center bore 214D, through chamber 210D, and through top bore 212D into airspace 110D. Helium in airspace 110D accelerates the transfer of heat from wafer 102 to hotplate 104D. Thus, a thermally conductive gas between wafer 102 and hotplate 104D promotes heat exchange between wafer 102 and hotplate 104D both during heating and during cooling.

The embodiments described herein are illustrative only and not limiting. The invention is limited only by the claims which follow.

## Claims

1. A method comprising:
placing a substantially flat article in proximity to a hotplate, which has a desired temperature, so as to form an airspace therebetween; and
introducing a thermally conductive, non-reactive gas into the airspace.

2. The method of claim 1 further comprising:
heating the gas prior to the step of introducing the gas into the airspace.

3. The method of claim 1 or 2 further comprising:
bringing the gas to the temperature of the hotplate prior to the step of introducing the gas into the airspace.

4. The method of claim 3, wherein the step of bringing the gas to the temperature of the hotplate comprises:
introducing the gas into a bore in the hotplate which opens into the airspace between the hotplate and the flat article.

5. The method of any one of claims 1 to 4, wherein the desired temperature is room temperature.

6. The method of any one of claims 1 to 5, wherein the thermally conductive, non-reactive gas is helium.

7. The method of any one of claims 1 to 6, wherein the step of introducing the gas comprises:
(a) introducing the gas into the airspace for a first period of time; and
(b) ceasing introduction of the gas into the airspace for a second period of time.

8. The method of claim 7, wherein steps (a) and (b) are repeated so as to alternately introduce gas for a first period of time and cease introduction of gas for a second period of time.

9. An apparatus for heating a substantially flat article to a desired temperature, the apparatus comprising:
a hot plate, mounted on a support structure, having a top side;
means for heating the hotplate to the desired temperature;
support means on the top side of the hotplate for supporting the flat article in proximity to the hotplate and creating an airspace between the flat article and the hotplate;
a thermally conductive, non-reactive gas source connected to the support structure; and
means for introducing an amount of thermally conductive, non-reactive gas from the gas source into the airspace.

10. The apparatus of claim 9 further comprising means, connected to the gas source, for preheating the gas prior to introduction into the airspace.

11. The apparatus of claim 9 or 10, wherein the thermally conductive, non-reactive gas is helium and further wherein the thermally conductive, non-reactive gas source is a helium source.

12. The apparatus of claim 9, 10 or 11, wherein the hotplate has a bore therethrough and further wherein the means for introducing the gas into the airspace introduces the gas into the bore through the hotplate such that the gas is at the temperature of the hotplate when introduced into the airspace.

13. The apparatus of any one of claims 9 to 12, wherein the means for introducing the gas comprises:
a pressure regulator, coupled to the gas source and having an output, for regulating the pressure of the gas as the gas is released from the gas source;
a solenoid valve, coupled to the output of the pressure regulator, for selectively controlling the flow of the gas from the gas source through a solenoid valve output to the airspace; and
a flow meter, coupled to the solenoid valve output, for measuring the flow of gas from the gas source to the airspace.

14. The apparatus of any one of claims 9 to 13, wherein the support means is an annular bench which supports the flat article near the outer edge of the flat article.

15. The apparatus of claim 14, wherein the annular bench includes an annular vacuum hold-down groove.

16. An apparatus for cooling a substantially flat article to a desired temperature, the apparatus comprising:
a chill plate, mounted on a support structure and having a desired temperature, having a top side;
support means on the top side of the hotplate for supporting the flat article in proximity to the hotplate and creating an airspace between the flat article and the chill plate;
a thermally conductive, non-reactive gas source connected to the support structure; and
means for introducing an amount of thermally conductive, non-reactive gas from the gas source into the airspace.
